# NEUE EUROPÄISCHE PATENTSCHRIFT

(11) **EP 0 643 329 B2**
(45) Veröffentlichungstag und Bekanntmachung des Hinweises auf die Entscheidung über den Einspruch: **06.02.2002**
(45) Hinweis auf die Patenterteilung: 23.12.1998
(21) Anmeldenummer: 94810474.0
(22) Anmeldetag: 17.08.1994
(51) Int. Cl.: G03F 7/032, G03F 7/075, G03C 9/08

(54) **Flüssige strahlungshärtbare Zusammensetzung, insbesondere für die Stereolithographie**
Radiation curable liquid composition, particularly for stereolithography
Composition liquide durcissable par rayonnement, en particulier pour la stéréolithographie

(30) Priorität: 26.08.1993 CH 254193
(43) Veröffentlichungstag der Anmeldung: 15.03.1995
(73) Patentinhaber: Vantico AG, 4057 Basel (CH)
(72) Erfinder: Wolf, Jean-Pierre, Dr., CH-1791 Courtaman (CH); Schulthess, Adrian, Dr., CH-1734 Tentlingen (CH); Steinmann, Bettina, Dr., CH-1724 Praroman (CH); Hunziker, Max, Dr., CH-3186 Düdingen (CH)

(56) Entgegenhaltungen:
- EP-A- 0 176 481
- EP-A- 0 425 441
- EP-A- 0 535 828
- EP-A- 0 582 152
- WO-A-93/14443
- JP-A- 4 100 835
- US-A- 4 443 581
- US-A- 4 833 218
- US-A- 5 032 662
- US-A- 5 070 169

## Beschreibung

Die vorliegende Erfindung bezieht sich auf eine flüssige strahlungshärtbare Zusammensetzung, insbesondere für die Stereolithographie, auf Basis mindestens einer Verbindung, die radikalisch polymerisierbare Gruppen aufweist, und mindestens eines für die Polymerisierung der genannten Verbindungen geeigneten Photoinitiators, auf bestimmte neue Polyoxyalkylen-Polysiloxan-Blockcopolymere. die neben anderen schon bekannten Blockcopolymeren dieses Typs als eine sehr vorteilhafte Formulierungskomponente für derartige Zusammensetzungen geeignet sind, sowie auf Verfahren zur Verarbeitung dieser Zusammensetzungen.

Beim stereolithographischen Verfahren, wie es z. B. aus dem US-Patent 4,575.330 bekannt ist, werden dreidimensionale Formkörper schichtweise aus flüssigen strahlungshärtbaren Zusammensetzungen in der Weise aufgebaut. dass man jeweils eine dünne Schicht der Zusammensetzung mit Hilfe von aktinischer Strahlung in definierter Weise so vorhärtet, dass die Schicht gerade die gewünschte Querschnittsform des Formkörpers an dieser Stelle aufweist, und dabei gleichzeitig an die im Schritt zuvor gehärtete Schicht des Formkörpers anpolymerisiert wird. Der auf diese Weise erhaltene Formkörper wird gegebenenfalls noch nachgehärtet, was z. B. thermisch erfolgen kann.

Prinzipiell sind für die Stereolithographie flüssige Zusammensetzungen mit strahlungshärtbaren Komponenten sowie Photoinitiatoren geeignet. Will man Formkörper erhalten, die in der Praxis wirklich einsetzbar sind, so müssen im allgemeinen kompliziert abgestimmte und formulierte Zusammensetzungen eingesetzt werden. Bewährt haben sich insbesondere Systeme auf Basis von Verbindungen mit radikalisch polymerisierbaren Gruppen, insbesondere auf Basis von Polyacrylaten und/oder -methacrylaten, wie sie beispielsweise aus der EP-A-0 378 144 bekannt sind. Die dort beschriebenen Gemische, die di- und polyfunktionelle Acrylate und/oder Methacrylate sowie gewisse Monomere mit einer einzigen Kohlenstoffdoppelbindung und geeignete Photoinitiatoren für die genannten Komponenten enthalten, ergeben Formkörper, die eine hohe Glasübergangstemperatur aufweisen und auch mechanische sowie verarbeitungtechnische Eigenschaften aufweisen, die für viele Anwendungsgebiete geeignet sind. Das Material ist jedoch ziemlich spröde. Daher ist eine manchmal erwünschte spanabhebende Nachbearbeitung des stereolithographisch hergestellten Formkörpers schwierig.

Weniger sprödes Materials kann mit Stereolithographieharzformulierungen erhalten werden, denen bestimmte Polyurethanacrylate und/oder -methacrylate zugesetzt sind. Solche Gemische sind z. B. in der EP-A-0 425 441 beschrieben, ihre Verwendung hat jedoch den Nachteil, dass die Glasübergangstemperatur des ausgehärteten Materials sinkt und auch die Viskosität der Stereolithographiegemische sehr stark ansteigen kann.

Es hat sich nunmehr gezeigt, dass Material von verbesserter Schlagzähigkeit erhalten werden kann, ohne dass der Tg-Wert und die Wärmeformbeständigkeit des Materials nennenswert emiedrigt werden, wenn man Zusammensetzungen auf Basis von Verbindungen mit radikalisch polymerisierbaren Gruppen und von Photoinitiatoren zu dessen Herstellung verwendet, denen Polyoxyalkylen-Polysiloxan-Blockcopolymere der weiter unten genannten Formeln (I), (II) oder (III) zusetzt sind. Auch die Viskosität der flüssigen Ausgangsgemische wird durch diese Modifizierung nicht nachteilig beeinfusst, wie es beispielsweise bei Einsatz anderer Copolymere anstatt der erfindungsgemässen Polyoxyalkylen-Polysiloxan-Blockcopolymeren der Fall ist, die oftmals zu einer kräftigen Erhöhung der Viskosität führen.

Die vorliegende Erfindung betrifft daher eine flüssige strahlungshärtbare Zusammensetzung, für die Stereolithographie, auf Basis mindestens einer Verbindung, die radikalisch polymerisierbare Gruppen aufweist, und mindestens eines für diese Polymerisierung geeigneten Photoinitiators, dadurch gekennzeichnet, dass sie zusätzlich ein Polyoxyalkylen-Polysiloxan-Blockcopolymer enthäh, das aus den Copolymeren der chemischen Formeln

(I): R¹-(OC_{c}H_{2c})_{d}-{[T]-(C_{c}H_{2c}O)_{d-1}-(C_{c}H_{2c})}_{g}-OR¹,

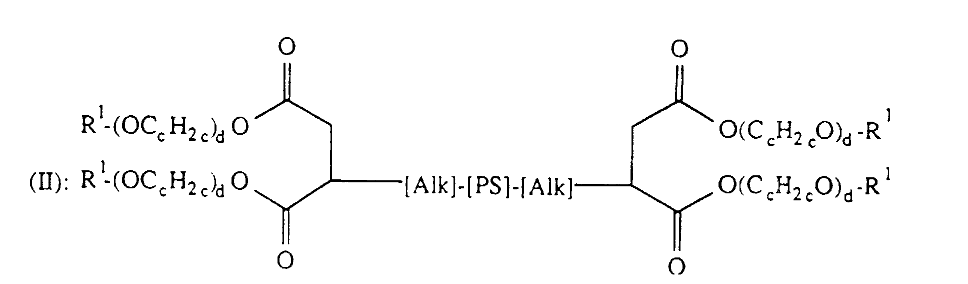

und 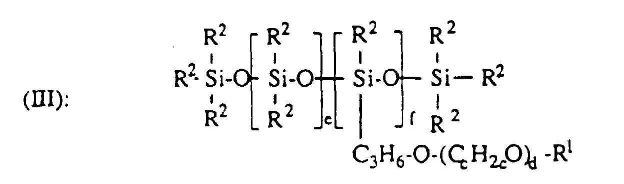 ausgewählt ist, in einer Menge von 5 bis 50 Gewichtsprozent der Zusammensetzung, wobei die einzelnen Symbole jeweils die nachfolgende Bedeutung haben:
- R¹: ein Rest ausgewählt aus einem Wasserstoffatom und einer C₁-C₈-Alkylgruppe;
- c: eine Zahl von 1 bis 8 entsprechend der durchschnittlichen Anzahl von Kohlenstoffatomen einer Alkyleneinheit in einer Polyoxyalkylengruppe (C_{c}H_{2c}O)_{d};
- d: eine ganze Zahl von 1 bis 100;
- g: eine ganze Zahl von 1 bis 4;
- [T]: eine Gruppe ausgewählt aus den Gruppen der Formeln T1 bis T12:

T1: -O-[PS]-O-,

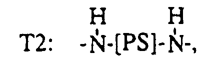

T3: -O-[Alk]-[PS]-[Alk]-O-,

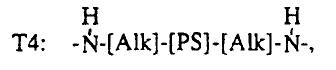

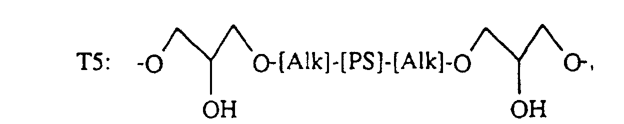

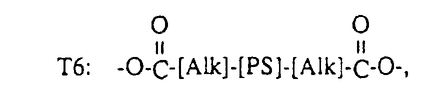

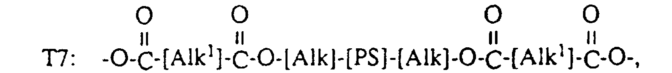

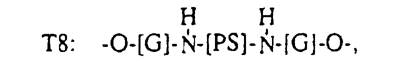

T9: -O-[G]-O-[PS]-O-[G]-O-,

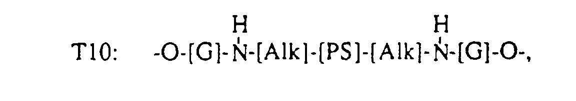

T11: -O-[G]-O-[Alk]-[PS]-[Alk]-O-[G]-O-,

T12: -O-[G]-O-(CₘH₂ₘO)ₙ-[Alk]-[PS]-[Alk]-(OCₘH₂ₘ)ₙ-O-[G]-O-;
- [PS]: eine Polysiloxangruppe der Formel 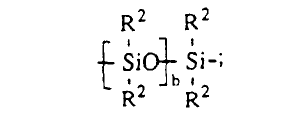
- R²: eine Gruppe ausgewählt aus Methyl und Phenyl;
- b: eine ganze Zahl von 1 bis 100:
- [Alk]: eine Alkylengruppe mit 3 bis 10 Kohlenstoffatomen;
- [Alk¹]: eine Alkylengruppe mit 1 bis 20 Kohlenstoffatomen;
- m: eine Zahl von 1 bis 8 entsprechend der durchschnittlichen Anzahl von Kohlenstoffatomen einer Alkyleneinheit in einer Polyoxyalkylengruppe (CₘH₂ₘO)ₙ;
- n: eine ganze Zahl von 1 bis 50;
- [G]: eine Gruppe der Formel 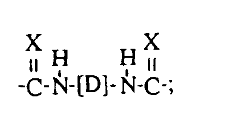
- X: ein Atom ausgewählt aus Sauerstoff- und Schwefelatomen;
- [D]: ein zweiwertiger organischer Rest mit mindestens 2 Kohlenstoffatomen;
- e: eine ganze Zahl von 1 bis 100 und
- f: eine ganze Zahl von 1 bis 50.

Die Symbole c und m geben die Anzahl von Kohlenstoffatomen an, die sich durchschnittlich für eine Alkyleneinheit in der entsprechenden Polyoxyalkylengruppe errechnet. Die genannten Symbole müssen daher nicht unbedingt ganzzahlig sein, da es sich bei dem Polyoxyalkylenblock auch um Mischpolymerisate aus Monomeren mit unterschiedlicher Anzahl von Kohlenstoffatomen handeln kann, die zudem in unterschiedlichen Verhältnissen eingesetzt werden können. Beispiele für übliche Monomere sind hierbei Ethylenoxid, Propylenoxid oder Tetrahydrofuran.

[D] ist vorzugsweise ausgewählt aus Alkylengruppen mit 2 bis 8 Kohlenstoffatomen und zweiwertigen Resten mit höchstens 30, insbesondere mit höchstens 20 Kohlenstoffatomen, wobei die letztgenannten Reste mindestens einen sechsgliedrigen Kohlenstoffring enthalten, der unsubstituiert ist oder einen oder mehrere geradkettige oder verzweigte C₁-C₄-Alkylsubstituenten auf weist.

[Alk] ist bevorzugt eine -(CH₂)₃-Gruppe.

Die vorgenannten Blockcopolymere von Formel (I) und (II) sind teilweise noch neu, insbesondere diejenigen, bei denen die Symbole die nachfolgende Bedeutung haben:
- R¹: ein Rest ausgewählt aus einem Wasserstoffatom und einer C₁-C₈-Alkylgruppe;
- c: eine Zahl von 1 bis 4 entsprechend der durchschnittlichen Anzahl von Kohlenstoffatomen einer Alkyleneinheit in einer Polyoxyalkylengruppe (C_{c}H_{2c}O)_{d};
- d: eine ganze Zahl von 7 bis 25;
- g: 1;
- [T]: eine Gruppe der Formel 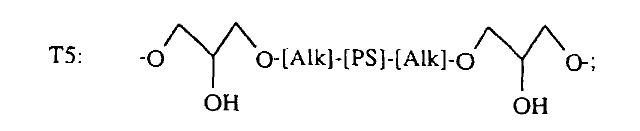
- [PS]: eine Polysiloxangruppe der Formel 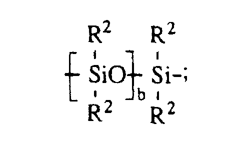
- R²: Methyl;
- b: eine ganze Zahl von 5 bis 50;
- [Alk]: eine Alkylengruppe mit 3 bis 10 Kohlenstoffatomen.

Diese neuen Polyoxyalkylen-Polysiloxan-Blockcopolymere gehören ebenfalls zum Gegenstand der Erfindung. [Alk] ist auch hierbei bevorzugt eine -(CH₂)₃-Gruppe.

Copolymere der Formel (I), bei denen [T] die Bedeutung T1 oder T2 hat, sind beispielsweise durch Umsetzung des gewünschten wasserstoffterminierten Polysiloxans mit dem gewünschten Polyoxyalkylendiol beziehungsweise -diamin gemäss folgendem Schema erhältlich: 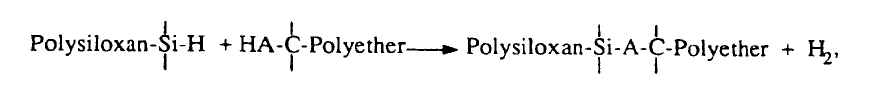 wobei A entweder ein Sauerstoffatom oder eine NH-Gruppe bedeutet. Geeignet ist auch die Umsetzung von α,ω-Dichlorpolysiloxanen mit den entsprechend terminierten Polyethern gemäss US-A-5,032,662. Eine Übersicht über Darstellungsverfahren für Blockcopolymere dieses Typs findet sich z. B. in Allen Noshay, James E. McGrath, "Block Copolymers"; Academic Press New York 1977, S. 401 ff. Copolymere der Formel (I), die O-[Alk]-[PS]-[Alk]-O-Gruppen aufweisen, können z. B. aus Polysiloxanen des Typs R¹⁶O-[Alk]-[PS]-[Alk]-OR¹⁶, worin R¹⁶ 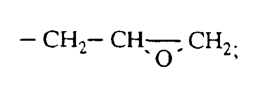 -CH₂-CH(OH)-CH₂OH (bei Copolymeren mit [T] = T5) oder Wasserstoff (bei Copolymeren mit [T] = T3) bedeutet, die z. B. gemäss oder analog zu der in der US 4,853,453 beschriebenen Verfahrensweise erhältlich sind, hergestellt werden, indem man diese Polysiloxane in üblicher Weise mit Polyoxyalkylendiolen zu den gewünschten Polysiloxan-Polyoxyalkylen-Blockcopoymeren umsetzt. Copolymere der Formel (I) mit [T] = T4 können analog aus Polysiloxanen des Typs H₂N-[Alk]-[PS]-[Alk]-NH₂ hergestellt werden. Die Herstellung von Copolymeren der Formel (I), bei denen [T] die Bedeutung T5 und [Alk] die Bedeutung -(CH₂)₃- hat, kann in besonders einfacher Weise auch aus dem Umsetzungsprodukt eines wasserstoffterminierten Polysiloxans der Formel H-[PS]-H mit Allylglycidylether, einer grosstechnisch verfügbaren Substanz (Alcolac, Inc., Rhône-Poulenc, CPS Chemical Co., Inc) erfolgen. Eine entsprechende Vorschrift findet sich z. B. in Comprehensive Handbook of Hydrosilylation, Pergamon Press, Oxford 1991. Für die Herstellung von Blockcopolymeren der Formel (I), worin die Gruppe [T] die Bedeutung T7 hat, müssen Polysiloxane der Formel HO-[Alk]-[PS]-[Alk]-OH dagegen zunächst noch mit Dicarbonsäuren des Typs HOOC-[Alk¹]-COOH verlängert werden. Für Copolymere, bei denen die Gruppe [T] eine der Bedeutungen T8 bis T12 hat, ist weiterhin noch die Umsetzung mit dem gewünschten Diisocyanat der Zusammensetzung OCN-[D]-NCO oder dem entsprechenden Dithioisocyanat erforderlich. Hierzu können entweder das Diisocyanat oder Diisothiocyanat gleichzeitig mit dem Polysiloxan und dem Polyoxyalkylendiol beziehungsweise dem entsprechenden Diamin umgesetzt werden, oder es kann zunächst in einem gesonderten Schritt eine Umsetzung des Polysiloxans oder Polyetherdiols mit dem Diisocyanat oder Dithioisocyanat erfolgen, an die sich die Reaktion mit der noch verbleibenden Komponente des Blockcopolymeren anschliesst. Im Falle des Copolymers mit [T] = T12 wird hierbei als Polysiloxan ein Reaktionsprodukt von HO-[Alk]-[PS]-[Alk]-OH mit einem Polyoxyalkylendiol der Formel HO-(CₘH₂ₘO)ₙ-H oder ein Reaktionsprodukt von HO-[Alk]-[PS]-[Alk]-OH mit geeigneten Monomeren, wie beispielsweise Ethylenoxid, Propylenoxid oder Tetrahydrofuran oder Gemischen zweier oder mehrerer derartiger Komponenten, eingesetzt.

Die Herstellung von Blockcopolymeren der Formel (II) kann ausgehend von den gewünschten Polyoxyalkylendiolen und von Polysiloxanen der Formel 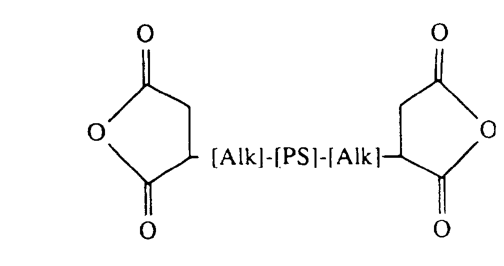 erfolgen. Die zuletzt genannten Polysiloxane sind z. B. durch Umsetzung von wasserstoffterminierten Polysiloxanen mit Bernsteinsäurederivaten der Formel 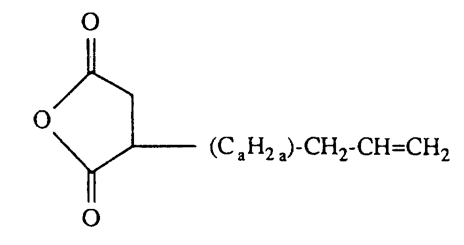 herstellbar, wobei a einer ganzen Zahl von 0 bis 7 entspricht, und sind auch kommerziell erhältlich. Für die besonders bevorzugten Copolymere der Formel (II), bei denen [Alk] -(CH₂)₃- bedeutet, kann die erforderliche Allylbernsteinsäure sehr elegant z. B. aus Propen und Maleinsäureanhydrid gemäss D.D. Phillips, T. B. Hill, J. Am. Chem. Soc. 1958, 80, S. 3663 hergestellt werden.

Erfindungsgemäss einsetzbare Blockcopolymere der Formel (III) finden z. B. als Bestandteil von Kosmetika Verwendung. Sie sind kommerziell erhältlich, z. B. unter der Bezeichnung DOW CORNING® 190 und 193 oder Silwet® L 7500, L-7600, L-7607 bzw. L 77 (UNION CARBIDE).

Die Polysiloxan-Polyoxyalkylen-Blockcopolymeren sind im allgemeinen in einer Menge von 5 bis 50 Gewichtsprozent in den erfindungsgemässen Zusammensetzungen enthalten, insbesondere in einer Menge von 10 bis 35 Gewichtsprozent.

Bevorzugt sind diejenigen der zuvor angeführten Zusammensetzungen, die Polyoxyalkylen-Polysiloxan-Blockcopolymere der Formel (I), (II) oder (III) enthalten, worin
- R¹: einen Rest ausgewählt aus einem Wasserstoffatom und einer C₁-C₄-Alkylgruppe;
- R²: eine Methylgruppe;
- [Alk]: eine -(CH₂)₃-Gruppe;
- [Alk¹]: eine Alkylengruppe mit 2 bis 10, insbesondere 2 bis 4 Kohlenstoffatomen;
- X: ein Sauerstoffatom;
- [D]: einen zweiwertigen organischen Rest ausgewählt aus den Resten der nachstehenden Formeln: 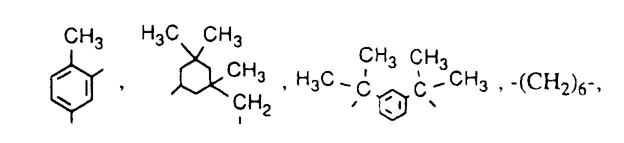 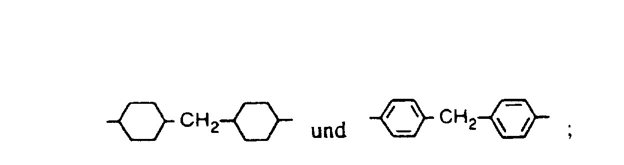
- c: eine Zahl von 2 bis 4;
- d: eine ganze Zahl von 5 bis 50;
- b: eine ganze Zahl von 10 bis 50;
- m: xeine Zahl von 2 bis 4;
- n: eine ganze Zahl von 5 bis 20;
- e: eine ganze Zahl von 1 bis 50 und
- f: eine ganze Zahl von 1 bis 25 bedeuten.

Ganz besonders bevorzugt sind erfindungsgemässe Zusammensetzungen mit Blockcopolymeren der Formel (I), (II) oder (III), worin
- R¹: eine Methylgruppe;
- [Alk]: und
- [Alk¹]: jeweils eine -(CH₂)₃-Gruppe:
- c: 2;
- d: im Fall einer Verbindung der Formel (I) oder (II) eine ganze Zahl von 7 bis 25 und im Fall einer Verbindung der Formel (III) eine ganze Zahl von 2 bis 20;
- g: 1;
- m: 2 und
- n: eine ganze Zahl von 7 bis 20 bedeuten.

Als Verbindungen, die radikalisch polymerisierbare Gruppen aufweisen, enthalten die erfindungsgemässen Zusammensetzungen bevorzugt Mischungen mit den folgenden Komponenten:
(i) difunktionellen monomeren oder polymeren Acrylaten oder Methacrylaten;
(ii) tri- oder polyfunktionellen Acrylaten oder Methacrylaten;
(iii) ungesättigten monomeren Verbindungen der Formel 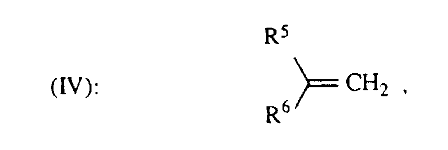
worin
- R⁵: einen Rest ausgewählt aus einem Wasserstoffatom und einer Methylgruppe und
- R⁶: ein Rest der Formel 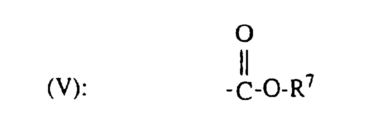 bedeuten, in der
- R⁷: für einen Rest ausgewählt aus Tetrahydrofurfuryl-, Cyclohexyl-, 2-Phenoxyethyl-, Benzyl-, Isobornyl-, Glycidyl-, Dicyclopentyl-, Morpholinoethyl-, Dimethylaminoethyl- und geradkettigen sowie verzweigten C₁-C₂₀-Alkylresten steht, und im Falle, dass R⁵ ein Wasserstoffatom darstellt, R⁶ zusätzlich zu den vorgenannten Resten auch einen Rest ausgewählt aus Pyrolidon-2-yl-, Imidazonyl-, Carbazolyl-, Anthracenyl-, Phenyl-, C₅-C₈-Cycloalkyl-, Naphthenyl-, 2-Norbomyl-, Pyridyl-, N-Caprolactamyl, Formamidyl-, Acetamidyl und Toluolylresten bedeuten kann.

Sehr gut für die Stereolithographie geeignet sind hierbei Mischungen, die mindestens je einen Vertreter der oben genannten Komponenten (i), (ii) und (iii) enthalten.

Für die Komponente (i) eignen sich beispielsweise die Diacrylat- und Dimethacrylatester von aliphatischen oder cycloaliphatischen Diolen, wie 1,3-Butylenglykol, 1,4-Butandiol, Neopentylglykol, 1,6-Hexandiol, Diethylenglykol, Triethylenglykol, Tetraethylenglykol, Polyethylenglykol-400, Polyethylenglykol-600, Tripropylenglykol, ethoxyliertes oder propoxyliertes Neopentylglykol, 1,4-Dihydroxymelhylcyclohexan, 2,2-Bis-(4-hydroxycyclohexyl)-propan oder Bis-(4-hydroxycyclohexyl)-methan, die gegebenenfalls alkoxyliert, insbesondere ethoxyliert oder propoxyliert, oder aber glycidylisiert sein können. Solche monomeren oder oligomeren Di(meth)acrylate sind zum Teil auch im Handel erhältlich, beispielsweise unter der Produktbezeichnung SR-348 für ethoxyliertes Bisphenol A-dimethacrylat und unter der Produktbezeichnung SR-349 für ethoxyliertes Bisphenol A-diacrylat von der Firma SARTOMER Company. Die Verbindungen weisen bevorzugt ein Molekulargewicht von 200 bis 1000 auf.

Für die Komponente (ii) des oben angeführten Gemisches können beispielsweise eingesetzt werden:
1,1,1-Trimethylolpropantriacrylat oder -methacrylat, ethoxyliertes 1,1,1-Trimethylolpropantriacrylat oder -methacrylat, Pentaerythritoltetraacrylat, Pentaerythritolmonohydroxytriacrylat oder -methacrylat, Dipentaerythritolmonohydroxypentaacrylat oder -methacrylat. Solche Verbindungen sind bekannt und zum Teil im Handel erhältlich, beispielsweise von der Firma SARTOMER Company unter der Produktebezeichnung SR-295, SR-350, SR-351, SR-367, SR-399, SR-444 und SR-454. Die Verbindungen dieses Typs weisen bevorzugt ein Molekulargewicht zwischen ca. 200 und 500.

Im allgemeinen sind in den genannten Gemischen etwa 20 bis 80, bevorzugt 30 bis 80, Gewichtsprozent der Komponente (i), 5 bis 25 Gewichtprozent der Komponente (ii) sowie 1 bis 25 Gewichtsprozent der Komponente (iii) enthalten.

Besonders bevorzugt sind erfindungsgemässe Zusammensetzungen, die als Komponente (i) zumindest eine Verbindung der Formel 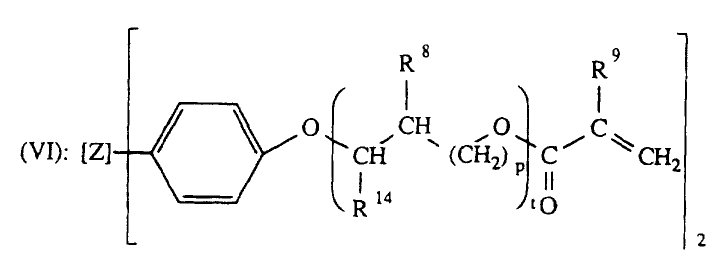 enthalten, worin
- p: 0 oder 1,
- t: 0 oder 1 oder, wenn p den Wert 0 hat, eine ganze Zahl von 1 bis 3,
- [Z]: -O-, -S-, -SO₂- oder -C(R¹⁰)(R¹¹)-,
- R¹⁰: sowie
- R¹¹: unabhängig voneinander jeweils einen Rest ausgewählt aus einem Wasserstoffatom, -CF₃ und Methyl,
- R¹⁴: wenn p den Wert 0 hat, ein Wasserstoffatom oder Methyl und, wenn p den Wert 1 hat, ein Wasserstoffatom,
- R⁸: wenn p den Wert 0 hat, ein Wasserstoffatom und wenn p den Wert 1 hat, Hydroxyl und
- R⁹: ein Wasserstoffatom oder Methyl bedeuten,
insbesondere wenn sie als Komponente (ii) ein Triacrylat oder Trimethacrylat der Formel

(VII): R¹²-CH₂-C(CH₂-R¹³)₃

enthalten, worin
- R¹²: Methyl oder einen Rest der Formel 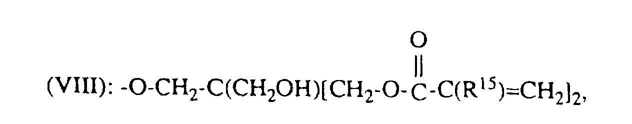
- R¹⁵: unabhängig voneinander jeweils ein Wasserstoffatom oder Methyl und
- R¹³: einen Rest der Formel 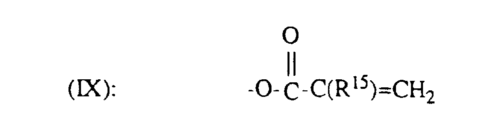 darstellen.

Ganz besonders gute Ergebnisse werden schliesslich mit Zusammensetzungen erhalten, die als Komponente (i) zumindest zwei verschiedene Verbindungen der Formel (VI) enthalten, wobei
- [Z]: in beiden Verbindungen eine -C(CH₃)₂- Gruppe bedeutet und
- p: in der Formel einer der beiden Verbindungen die Bedeutung 0 und in der anderen Verbindung die Bedeutung 1 hat,
und als Komponente (iii) entweder 1-Vinylpyrrolidon, Phenoxyethylacrylat, Phenoxyethylmethacrylat oder ein Gemisch von mindestens zwei der genannten Komponenten.

Besonders bevorzugt sind diese Zusammensetzungen, wenn mehr als 50 Gewichtsprozent der Komponente (i) aus Verbindungen der Formel (VI) besteht, bei denen p = 1 ist.

In den erfindungsgemässen Zusammensetzungen können alle Typen von Photoinitiatoren eingesetzt werden, welche bei der entsprechenden Bestrahlung freie Radikale bilden. Typische Verbindungen bekannter Photoinitiatoren sind Benzoine, wie Benzoin oder Benzoinether, z. B. Benzoinmethylether, Benzoinethylether und Benzoinisopropylether, Benzoinphenylether und Benzoinacetat, Acetophenone, wie Acetophenon, 2,2-Dimethoxyacetophenon, und 1,1-Dichloracetophenon, Benzil, Benzilketale, wie Benzildimethylketal und Benzildiethylketal, Anthrachinone, wie 2-Methylanthrachinon, 2-Ethylanthrachinon, 2-tert.-Butylanthrachinon, 1-Chloranthrachinon und 2-Amylanthrachinon, Triphenylphosphin, Benzoylphosphinoxide, wie beispielsweise 2,4,6-Trimethylbenzoyldiphenylphosphinoxid (Luzirin®TPO), Benzophenone, wie Benzophenon und 4,4'-Bis-(N,N'-dimethylamino)-benzophenon,Thioxanthone und Xanthone, Acridinderivate, Phenazinderivate, Quinoxalinderivate oder 1-Phenyl-1,2-propandion-2-O-benzoyloxim, 1-Aminophenylketone oder 1-Hydroxyphenylketone, wie 1-Hydroxycyclohexylphenylketon, Phenyl-(1-hydroxyisopropyl)-keton und 4-lsopropylphenyl(1-hydroxyisopropyl)-keton, welche alle bekannte Verbindungen darstellen.

Besonders geeignete Photoinitiatoren, welche gewöhnlich in Kombination mit einem HeCd-Laser als Strahlenquelle verwendet werden, sind Acetophenone, wie 2,2-Dialkoxybenzophenone und α-Hydroxyphenylketone, beispielsweise 1-Hydroxycyclohexylphenylketon oder (2-Hydroxyisopropyl)-phenylketon (= 2-Hydroxy-2,2-dimethylacetophenon).

Eine andere Klasse von Photoinitiatoren, die gewöhnlich bei Verwendung von Argonion-Lasern eingesetzt wird, sind die Benzilketale, wie beispielsweise Benzildimethylketal. Insbesondere verwendet man als Photoinitiator ein α-Hydroxyphenylketon, Benzildimethylketal oder 2,4,6-Trimethylbenzoyldiphenylphosphinoxid.

Eine weitere Klasse von geeigneten Photoinitiatoren stellen die ionischen Farbstoff-Gegenionverbindungen (ionic dye-counter ion compounds) dar, welche in der Lage sind, aktinische Strahlen zu absorbieren und freie Radikale zu erzeugen, die die Polymerisation von Substanzen, wie (Meth)acrylaten oder Vinylverbindungen, initiieren. Die erfindungsgemässen Gemische, welche ionische Farbstoff-Gegenionverbindungen enthalten, können auf diese Weise mit sichtbarem Licht im einstellbaren Wellenlängenbereich von 400-700 nm variabler gehärtet werden. Ionische Farbstoff-Gegenionverbindungen und deren Wirkungsweise sind bekannt, beispielsweise aus der EP-A-0 223 587 und den US-Patenten 4,751,102; 4,772,530 und 4,772,541. Als Beispiele für geeignete ionische Farbstoff-Gegenionverbindungen seien genannt die anionischen Farbstoff-Jodoniumionkomplexe, die anionischen Farbstoff-Pyrylliumionkomplexe und insbesondere die kationischen Farbstoff-Boratanionverbindungen der Formel 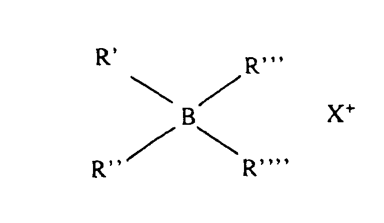 worin X⁺ für einen kationischen Farbstoff steht und R', R", R"' und R"" unabhängig voneinander je ein Alkyl, Aryl, Alkaryl, Allyl, Aralkyl, Alkenyl, Alkinyl, eine alicyclische oder gesättigte oder ungesättigte heterocyclische Gruppe bedeuten.

Die Photoinitiatoren werden in wirksamen Mengen zugesetzt, das heisst, in Mengen von etwa 0,1 bis etwa 10 Gewichtsprozent, bezogen auf die Gesamtmenge des Gemisches. Wenn die erfindungsgemässen Gemische für stereolithographische Verfahren verwendet werden, wobei normalerweise Laserstrahlen eingesetzt werden, ist es wesentlich, dass die Absorptionsfähigkeit der Gemische durch Typ und Konzentration des Photoinitiators so abgestimmt wird, dass die Härtungstiefe bei normaler Lasergeschwindigkeit ungefähr 0,1 bis 2,5 mm beträgt.

Die erfindungsgemässen Gemische können auch verschiedene Photoinitiatoren enthalten, welche gegenüber Strahlen von Emissionslinien unterschiedlicher Wellenlängen verschieden strahlungsempfindlich sind. Man erreicht dadurch beispielsweise eine bessere Ausnützung einer UV/VIS-Lichtquelle, welche Emissionslinien unterschiedlicher Wellenlänge ausstrahlt. Vorteilhaft ist es dabei, wenn die verschiedenen Photoinitiatoren so ausgewählt und in einer solchen Konzentration eingesetzt werden, dass bei den verwendeten Emissionslinien eine gleiche optische Absorption erzeugt wird.

Falls erwünscht können den erfindungsgemässen Gemischen die üblichen Additive zugesetzt werden, beispielsweise Stabilisatoren, wie UV-Stabilisatoren, Polymerisationsinhibitoren, Trennmittel, Benetzungsmittel, Verlaufsmittel, Sensibilisatoren, Antiabsetzmittel, oberflächenaktive Mittel, Farbstoffe, Pigmente oder Füllstoffe.

Die erfindungsgemässen Zusammensetzungen sollten bei einer Temperatur zwischen 20 und 30 °C bevorzugt eine Viskosität zwischen 200 und 5000 mPa·s aufweisen, insbesondere zwischen 500 und 3500 mPa·s.

Sie können in bekannter Weise hergestellt werden, beispielsweise durch Vormischen einzelner Komponenten und anschliessendes Vermischen dieser Vormischungen oder durch Vermischen aller Komponenten mittels üblicher Vorrichtungen, wie Rührbehälter, in Abwesenheit von Licht und gegebenenfalls bei leicht erhöhter Temperatur.

Die erfindungsgemässen Zusammensetzungen können durch Bestrahlen mit aktinischem Licht, beispielsweise mittels Elektronen- oder Rontgenstrahlen, UV- oder VIS-Licht. das heisst. mit Strahlen im Wellenlängenbereich von 280-650 nm polymerisiert werden. Besonders geeignet sind Laserstrahlen von HeCd. Argon oder Stickstoff sowie Metalldampf und NdYAG-Laser mit vervielfachter Frequenz. Es ist dem Fachmann bekannt. dass für jede gewählte Lichtquelle der geeignete Photoinitiator ausgewählt und gegebenenfalls sensibilisiert werden muss. Man hat erkannt, dass die Eindringtiefe der Strahlen in die zu polymensierende Zusammensetzung und die Arbeitsgeschwindigkeit in direktem Zusammenhang mit dem Absorptionskoeffizienten und der Konzentration des Photoinitiators stehen. In der Stereolithographie werden vorzugsweise solche Photoinitiatoren eingesetzt, welche die höchste Anzahl von entstehenden freien Radikalen bewirken und die grösste Strahlungseindringtiefe in die zu polymerisierenden Zusammensetzungen ermöglichen.

Ein weiterer Erfindungsgegenstand ist schliesslich ein Verfahren zur Herstellung von dreidimensionalen Gegenständen aus den flüssigen, erfindungsgemässen Gemischen mittels stereolithographischen Verfahren, umfassend einen Schritt, bei dem die Oberfläche einer Schicht aus dem erfindungsgemässen, flüssigen Gemisch ganzflächig oder in einem vorbestimmten Muster mit einer UV/VIS-Lichtquelle bestrahlt wird, so dass sich in den bestrahlten Bereichen eine Schicht in einer gewünschten Schichtdicke verfestigt, dann eine neue Schicht aus den erfindungsgemässen Gemischen auf der verfestigten Schicht gebildet wird, die ebenfalls ganzflächig oder in einem vorbestimmten Muster bestrahlt wird, und wobei durch wiederholtes Beschichten und Bestrahlen dreidimensionale Gegenstände aus mehreren aneinander haftenden, verfestigten Schichten erhalten werden.

Bei diesem Verfahren wird als Strahlungsquelle vorzugsweise ein Laserstrahl verwendet, der vorzugsweise computergesteuert ist.

Hierbei verwendet man die erfindungsgemässen Gemische zur Herstellung von photopolymerisierten Schichten, in Form von dreidimensionalen Gegenständen, die aus mehreren aneinander haftenden, verfestigten Schichten aufgebaut sind.

### Beispiel 1: Herstellung eines Polyoxyalkylen-Potydimethylsiloxan-Blockcopolymers aus Polyethylenglycolmonomethylether und einem Polysiloxan der Formel

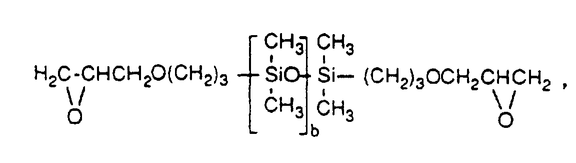

worin b die Zahl 10 ist und das Polysiloxan eine Epoxidzahl von 0,18 Äquivalenten/100 g aufweist.

Zu einer Lösung aus 0,1 Mol (110 g) des Polysiloxans (Hersteller: Wacker-Chemie GmbH, München) und 0.2 Mol (110 g) Polyethylenglycolmonomethylether (MG = 550) werden bei 100 °C eine Lösung von 1,8 g BF₃·Et₂O in 20 Milliliter Dioxan zugetropft. Nach beendeter Zugabe wird bei 130 °C bis zum Verschwinden des Epoxidgehaltes (16 h) weitergerührt. Die klare, leicht gelbliche Lösung wird am Hochvakuum (1,3·10⁻⁴ bar, 60 °C, 2 h) getrocknet.
Ausbeute: 200 g leicht gelbliches Öl, welches beim Stehenlassen kristallisiert.

### Beispiel 2: Herstellung eines Polyoxyalkylen-Polydimethylsiloxan-Blockcopolymers aus Polyethylenglycolmonomethylether und einem Polysiloxan der Formel

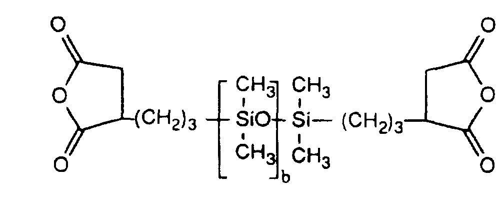

worin b = 25 ist und das eine Anhydridzahl von 1,0 Milliäquivalent/g aufweist.

Eine Lösung von 0,06 Mol (120 g) des Polysiloxans (Hersteller: Wacker-Chemie GmbH, München), 0,24 Mol (132 g) Polyethylenglycolmonomethylether (MG = 550) und 1,2 g p-Toluolsulfonsäure in 500 Milliliter Xylol wird am Wasserabscheider unter Rückfluss erhitzt, bis die theoretisch zu erwartende Wassermenge abgetrennt ist (ca. 30 h). Das Xylol wird am Rotationsverdampfer abgezogen und das entstehende gelbliche Öl am Hochvakuum (1,3·10⁻⁴ bar, 60°C, 2 h) getrocknet.

Ausbeute: 225 g gelbliches Öl, das beim Stehenlassen zum Teil kristallisiert.

### Beispiel 3: Herstellung eines Blockcopolymers aus Toluylen-2,4-diisocyanat, Polyethylenglycolmonomethylether und einem Polysiloxan der Formel

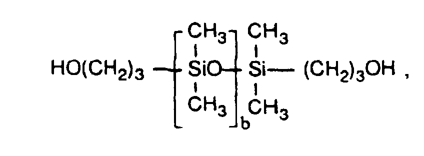

worin b = 10 ist und das eine Hydroxylzahl von 110 mg KOH/g aufweist.

Zu einer Mischung aus 0,15 Mol (22 Milliliter) Toluylen-2,4-Diisocyanat und 3 Tropfen Benzoylchlorid werden bei 60 °C unter Stickstoffatmosphäre 0,075 Mol (76,5 g) des Polysiloxans (IM® 11 der Wacker-Chemie GmbH, München) während 1,5 h zugetropft. Die Reaktionslösung wird noch 4 h bei 60 °C gerührt und der Gehalt an Isocyanat mittels Titration zu 1,53 Mol/kg bestimmt (Theorie: 1,46 Mol/kg). Anschliessend wird die Reaktionslösung auf 45 °C abgekühlt und 0,13 g Zinn-2-ethylhexanoat zugegeben. Unter Luftatmosphäre werden 0,16 Mol (118,9 g) Polyethylenglycolmonomethylether (MG = 750) langsam zugetropft. Es wird bis zum Verschwinden des Isocyanatgehaltes bei 45 °C gerührt (32 h).

Ausbeute 221 g orangefarbenes Öl, das bei Stehen langsam kristallisiert. GPC: Mₙ = 2450, M_{w}/Mₙ = 2,33; in THF mit Polystyrol als Standard).

### Beispiel 4: Herstellung eines Blockcopolymers aus Toluylen-2,4-diisocyanat, Polyethylenglycolmonomethylether und einem Polysiloxan der Formel

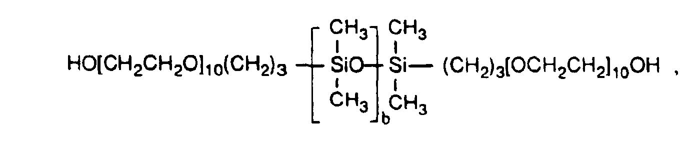

worin b = 15 ist und das eine Hydroxylzahl von 62 mg KOH/g aufweist (IM®22, Hersteller: Wacker-Chemie GmbH, München).

Es wird analog zu Beispiel 3 gearbeitet, wobei 0,025 Mol (40,06 g) des Polysiloxans, 0,05 Mol (7,4 Milliliter) Toluylen-2,4-diisocyanat und 0,05 Mol (97,64 g) Polyethylenglycolmonomethylether (MG = 2000) eingesetzt werden und 146 g des Produkts in Form einer gelblich orangenen kristallinen Masse erhalten werden.

### Beispiel 5:

90 Gramm eines flüssigen strahlungsempfindlichen Gemisches der Zusammensetzung

| | |
|---|---|
| 48,85 Gewichtsteile | Bisphenol-A-diglycidyldiacrylat |
| 25 Gewichtsteile | ethoxyliertes Bisphenol-A-dimethacrylat (SR 348*) |
| 12 Gewichtsteile | Trimethylolpropantrimethacrylat |
| 5 Gewichtsteile | 2-Phenoxyethylmethacrylat |
| 5 Gewichtsteile | 1-Vinyl-2-pyrrolidon |
| 4 Gewichtsteile | 1-Hydroxycyclohexylphenylmethanon (Irgacure®184) |
| 0,15 Gewichtsteile | 4-Methoxyphenol |

| | |
|---|---|
| *ex Sartomer Comp. | |

werden mit 10 Gramm eines kommerziellen
Polyoxyalkylen-Polysiloxan-Blockcopolymers (IM®22; Handelsprodukt der Wacker-Chemie GmbH, München) vermischt und es wird noch einmal soviel 1-Hydroxycyclohexylphenylmethanon (Irgacure®184) zugegeben, dass die Konzentration dieses Photoinitiators in der Gesamtmischung 4 Gewichtsprozent beträgt. Die Zusammensetzung mit dem Blockcopolymer hat bei 30 °C eine Viskosität von 1500 mPa·s.

Mit Hilfe eines He/Cd-Lasers mit einer Bestrahlungsenergie von 40 mJ/cm² werden durch Bestrahlung der Mischung Formkörper hergestellt.

Die mechanischen Eigenschaften des mittels Laserstrahlen gehärteten Gegenstandes (green strength) und des durch Nachhärtung erhaltenen Gegenstandes werden an der Zugtestmaschine Lloyd® 500 der Firma Lloyd gemessen, wobei die Formkörper typischerweise eine Dimension von 50 Millimetern Länge und einen Querschnitt von 1,2 x 0,3 Millimetern aufweisen.

Die durch Laserhärtung erhaltenen Formkörper (Grünlinge) weisen folgende Eigenschaften auf:
Elastizitätsmodul (E-Modul) gemäss DIN 53371 = 15 N/mm².

Zur vollständigen Aushärtung werden die Grünlinge 30 Minuten (min) im Nachhärtungsschrank (PCA der Firma 3D Systems, Inc.) mit maximaler Strahlungsdosis bestrahlt. Die so erhaltenen Formkörper weisen folgende Eigenschaften auf:

| | |
|---|---|
| E-Modul | = 2418 N/mm². |
| Reissdehnung gemäss DIN 53455 | = 3 %. |

Zur Bestimmung der Schlagzähigkeit wird die Zusammensetzung zwischen zwei Glasplatten im Abstand von 4 mm gegossen und 30 min lang im Nachhärtungsschrank (PCA der Firma 3D Systems, Inc.) mit maximaler Strahlungsdosis ausgehärtet. Es werden Prüfkörper der Abmessung 50 x 10 x 4 mm hergestellt.

| | |
|---|---|
| Schlagzähigkeit (DIN 52453) | = 8,0 kJ/m². |

Die Glasübergangstemperatur (TMA; 10 °C/min; 0,5 N; bestimmt mit Mettler TA 4000) des Materials beträgt 92 °C.

Ohne Zugabe des Polyoxyalkylen-Polysiloxan-Blockcopolymers werden unter gleichen Bedingungen mit dem oben angeführten strahlungsempfindlichen Gemisch demgegenüber die folgenden Eigenschaftwerte erreicht:

| | |
|---|---|
| Viskosität bei 30 °C | = 2140 mPa·s |
| E-Modul der Grünlinge (40 mJ/cm²) | = 66,1 N/mm². |
| E-Modul der ausgehärteten Formlinge | = 2687,4 N/mm². |
| Reissdehnung | = 2,1 %. |
| Schlagzähigkeit | = 2,0 kJ/m². |
| Glasübergangstemperatur | = 95 °C. |

### Beispiel 6:

90 Gramm eines flüssigen strahlungsempfindlichen Gemisches aus Beispiel 5 werden mit 10 Gramm des Polyoxyalkylen-Polysiloxan-Blockcopolymers aus Beispiel 1 vermischt und es wird noch einmal soviel 1-Hydroxycyclohexylphenylmethanon (Irgacure® 184) zugegeben, dass die Konzentration dieses Photoinitiators in der Gesamtmischung 4 Gewichtsprozent beträgt (Zusammensetzung 6A). In gleicher Weise wird eine Zusammensetzung aus 70 Gramm des oben angeführten strahlungsempfindlichen Gemisches und 30 Gramm des Blockcopolymers aus Beispiel 1 hergestellt (Zusammensetzung 6B).

| Eigenschaft | Zusammensetzung | |
|---|---|---|
| | 6A | 6B |
| Viskosität bei 30 °C in mPa·s | 1750 | 1340 |
| E-Modul der Grünlinge (40 mJ/cm²) in N/mm² | 61,0 | 15,0 |
| E-Modul der ausgehärteten Formlinge in N/mm² | 2598,0 | 1686,0 |
| Reissdehnung in % | 3,3 | 6,1 |
| Schlagzähigkeit in kJ/m² | 9,0 | 11,0 |

### Beispiel 7:

90 Gramm eines flüssigen strahlungsempfindlichen Gemisches aus Beispiel 5 werden mit 10 Gramm des Polyoxyalkylen-Polysiloxan-Blockcopolymers aus Beispiel 3 vermischt und es wird noch einmal soviel 1-Hydroxycyclohexylphenylmethanon (Irgacure®184) zugegeben, dass die Konzentration dieses Photoinitiators in der Gesamtmischung 4 Gewichtsprozent beträgt (Zusammensetzung 7A). In gleicher Weise wird eine Zusammensetzung aus 70 Gramm des oben angeführten strahlungsempfindlichen Gemisches und 30 Gramm des Blockcopolymers aus Beispiel 3 hergestellt (Zusammensetzung 7B).

| Eigenschaft | Zusammensetzung | |
|---|---|---|
| | 7A | 7B |
| Viskosität bei 30 °C in mPa·s | 2620 | 3270 |
| E-Modul der Grünlinge (40 mJ/cm²) in N/mm² | 48,0 | 23,0 |
| E-Modul der ausgehärteten Formlinge in N/mm² | 2632,0 | 1525,0 |
| Reissdehnung in % | 3,0 | 7,0 |
| Schlagzähigkeit in kJ/m² | 9,0 | 11,0 |

### Beispiel 8:

90 Gramm eines flüssigen strahlungsempfindlichen Gemisches aus Beispiel 5 werden mit 10 Gramm des Polyoxyalkylen-Polysiloxan-Blockcopolymers aus Beispiel 4 vermischt und es wird noch einmal soviel Irgacure® 184 zugegeben, dass die Konzentration dieses Photoinitiators in der Gesamtmischung wieder 4 Gewichtsprozent beträgt (Zusammensetzung 8A). In gleicher Weise wird eine Zusammensetzung aus 70 Gramm des oben angeführten strahlungsempfindlichen Gemisches und 30 Gramm des Blockcopolymers aus Beispiel 4 hergestellt (Zusammensetzung 8B).

| Eigenschaft | Zusammensetzung | |
|---|---|---|
| | 8A | 8B |
| Viskosität bei 30 °C in mPa·s | 2470 | 3240 |
| E-Modul der Grünlinge (40 mJ/cm²) in N/mm² | 33,0 | 12,0 |
| E-Modul der ausgehärteten Formlinge in N/mm² | 2679,0 | 1664,0 |
| Reissdehnung in % | 3,0 | 5,0 |
| Schlagzähigkeit in kJ/m² | 7,0 | 12,0 |

## Patentansprüche

1. Flüssige strahlungshärtbare Zusammensetzung für die Stereolithographie auf Basis mindestens einer Verbindung die radikalisch polymerisierbare Gruppen aufweist, und mindestens eines für diese Polymerisierung geeigneten Photoinitiators **dadurch gekennzeichnet. dass** sie zusätzlich ein Polyoxyalkylen-Polysiloxan-Blockcopolymer enthalt, das aus den Copolymeren der chemischen Formeln
(I): R¹-(OC_{c}H_{2c})_{d}-{[T]-(C_{c}H_{2c}O)_{d-1}-(C_{c}H_{2c})}_{g}-OR¹, 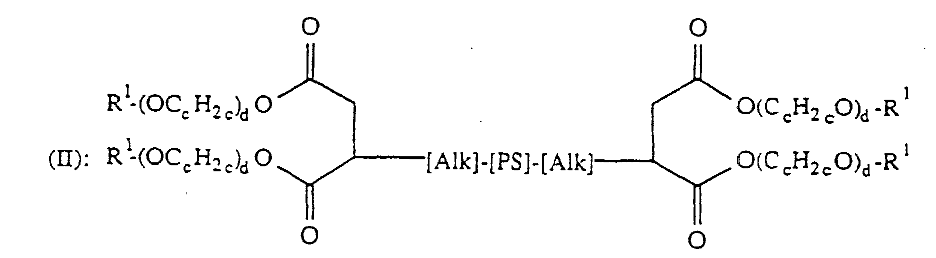
und 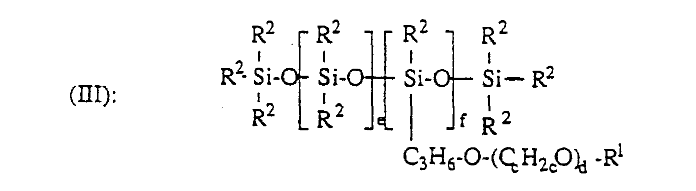 ausgewählt ist, in einer Menge von 5 bis 50 Gewichtsprozent der Zusammensetzung, wobei die einzelnen Symbole jeweils die nachfolgende Bedeutung haben:
R¹ ein Rest ausgewählt aus einem Wasserstoffatom und einer C₁-C₈-Alkylgruppe;
c eine Zahl von 1 bis 8 entsprechend der durchschnittlichen Anzahl von Kohlenstoffatomen einer Alkyleneinheit in einer Polyoxyalkylengruppe (C_{c}H_{2c}O)_{d};
d eine ganze Zahl von 1 bis 100;
g eine ganze Zahl von 1 bis 4;
[T] eine Gruppe ausgewählt aus den Gruppen der Formeln T1 bis T12:
T1: -O-[PS]-O-, 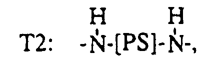
T3: -O-[Alk]-[PS]-[Alk]-O-, 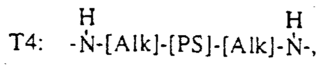 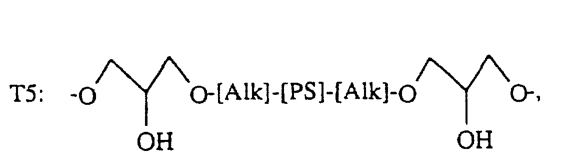 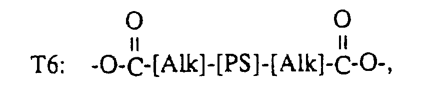 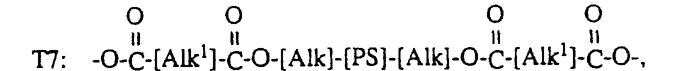 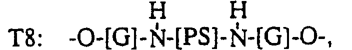
T9: -O-[G]-O-[PS]-O-[G]-O-, 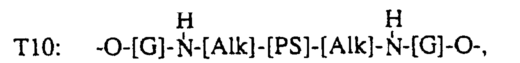
T11: -O-[G]-O-[Alk]-[PS]-[Alk]-O-[G]-O-,
T12: -O-[G]-O-(CₘH₂ₘO)ₙ-[Alk]-[PS]-[Alk]-(OCₘH₂ₘ)ₙ-O-[G]-O-;
[PS] eine Polysiloxangruppe der Formel 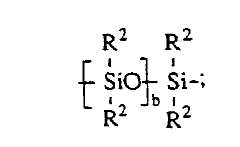
R² eine Gruppe ausgewählt aus Methyl und Phenyl;
b eine ganze Zahl von 1 bis 100;
[Alk] eine Alkylengruppe mit 3 bis 10 Kohlenstoffatomen;
[Alk¹] eine Alkylengruppe mit 1 bis 20 Kohlenstoffatomen;
m eine Zahl von 1 bis 8 entsprechend der durchschnittlichen Anzahl von Kohlenstoffatomen einer Alkyleneinheit in einer Polyoxyalkylengruppe (CₘH₂ₘO)ₙ;
n eine ganze Zahl von 1 bis 50;
[G] eine Gruppe der Formel 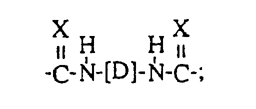
X ein Atom ausgewählt aus Sauerstoff- und Schwefelatomen;
[D] ein zweiwertiger organischer Rest mit mindestens 2 Kohlenstoffatomen;
e eine ganze Zahl von 1 bis 100 und
f eine ganze Zahl von 1 bis 50.

2. Zusammensetzung gemäss Anspruch 1, **dadurch gekennzeichnet, dass**
[D] ausgewählt ist aus:
Alkylengruppen mit 2 bis 8 Kohlenstoffatomen und
zweiwertigen Resten mit höchstens 30, insbesondere mit höchstens 20 Kohlenstoffatomen, wobei diese zweiwertigen Reste mindestens einen sechsgliedrigen Kohlenstoffring enthalten und unsubstituiert sind oder einen oder mehrere geradkettige oder verzweigte C₁-C₄-Alkylsubstituenten aufweisen.

3. Zusammensetzung gemäss Anspruch 2, **dadurch gekennzeichnet, dass**
R¹ einen Rest ausgewählt aus einem Wasserstoffatom und einer C₁-C₄-Alkylgruppe;
R² eine Methylgruppe;
[Alk] eine -(CH₂)₃-Gruppe;
[Alk¹] eine Alkylengruppe mit 2 bis 10 Kohlenstoffatomen;
X ein Sauerstoffatom;
[D] einen zweiwertigen organischen Rest ausgewählt aus den Resten der nachstehenden Formeln: 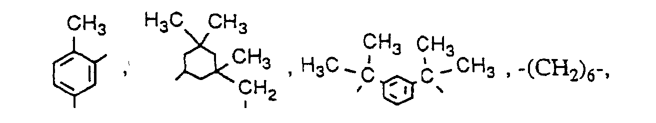 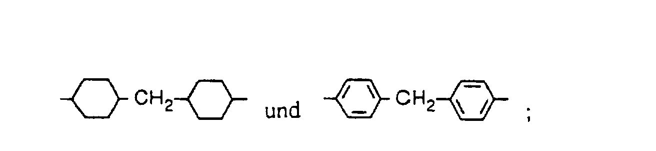
c eine Zahl von 2 bis 4;
d eine ganze Zahl von 5 bis 50;
b eine ganze Zahl von 10 bis 50;
m eine Zahl von 2 bis 4;
n eine ganze Zahl von 5 bis 20;
e eine ganze Zahl von 1 bis 50 und
f eine ganze Zahl von 1 bis 25 bedeuten.

4. Zusammensetzung gemäss Anspruch 3, **dadurch gekennzeichnet, dass**
R¹ eine Methylgruppe;
[Alk] und
[Alk¹] jeweils eine -(CH₂)₃-Gruppe;
c 2;
d im Fall einer Verbindung der Formel (I) oder (II) eine ganze Zahl von 7 bis 25 und im Fall einer Verbindung der Formel (III) eine ganze Zahl von 2 bis 20;
g 1;
m 2 und
n eine ganze Zahl von 7 bis 20 bedeuten.

5. Zusammensetzung nach einem der Ansprüche 1 bis 4, **dadurch gekennzeichnet, dass** die Verbindungen, die radikalisch polymerisierbare Gruppen aufweisen, eine Mischung darstellen, die folgende Komponenten enthält:
(i) ein difunktionelles monomeres oder polymeres Acrylat oder Methacrylat;
(ii) ein tri- oder polyfunktionelles Acrylat oder Methacrylat;
(iii) eine ungesättigte monomere Verbindung der Formel 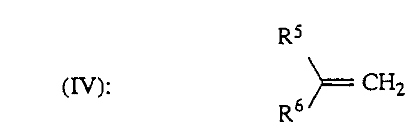 worin
R⁵ einen Rest ausgewählt aus einem Wasserstoffatom und einer Methylgruppe und
R⁶ einen Rest der Formel 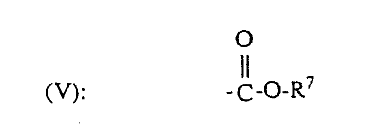 darstellen, wobei
R⁷ für einen Rest ausgewählt aus Tetrahydrofurfuryl-, Cyclohexyl-, 2-Phenoxyethyl-, Benzyl-, Isobornyl-, Glycidyl-, Dicyclopentyl-, Morpholinoethyl-, Dimethylaminoethyl- und geradkettigen sowie verzweigten C₁-C₂₀-Alkylresten steht, und im Falle, dass R⁵ ein Wasserstoffatom darstellt, R⁶ zusätzlich zu den vorgenannten Resten auch einen Rest ausgewählt aus Pyrrolidon-2-yl-, Imidazonyl-, Carbazolyl-, Anthracenyl-, Phenyl-, C₅-C₈-Cycloalkyl-, Naphthenyl-, 2-Norbornyl-, Pyridyl-, N-Caprolactamyl-, Formamidyl-, Acetamidyl und Toluolylresten bedeuten kann.

6. Zusammensetzung nach Anspruch 5, **dadurch gekennzeichnet, dass** sie als Komponente (i) zumindest eine Verbindung der Formel 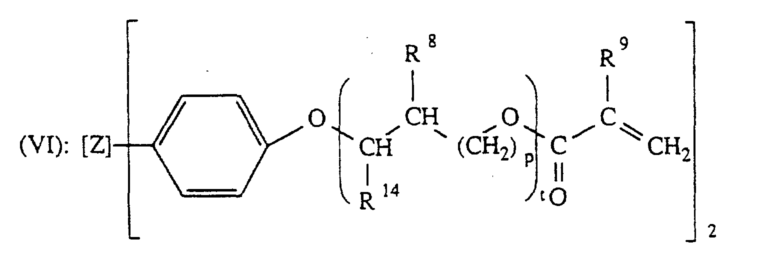 enthält, worin
p 0 oder 1,
t 0 oder 1 oder, wenn p den Wert 0 hat, eine ganze Zahl von 1 bis 3,
[Z] -O-, -S-, -SO₂- oder -C(R¹⁰)(R¹¹)-,
R¹⁰ sowie
R¹¹ unabhängig voneinander jeweils einen Rest ausgewählt aus einem Wasserstoffatom, -CF₃ und Methyl,
R¹⁴ wenn p den Wert 0 hat, ein Wasserstoffatom oder Methyl und, wenn p den Wert 1 hat, ein Wasserstoffatom,
R⁸ wenn p den Wert 0 hat, ein Wasserstoffatom und wenn p den. Wert 1 hat, Hydroxyl und
R⁹ ein Wasserstoffatom oder Methyl bedeutet; und
als Komponente (ii) ein Triacrylat oder -Trimethacrylat der Formel
(VII): R¹²-CH₂-C(CH₂-R¹³)₃
enthält, worin
R¹² Methyl oder einen Rest der Formel 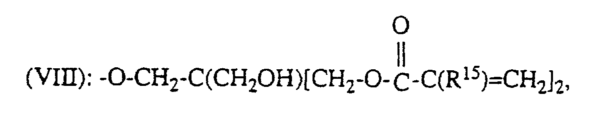
R¹⁵ unabhängig voneinander jeweils ein Wasserstoffatom oder Methyl und
R¹³ einen Rest der Formel 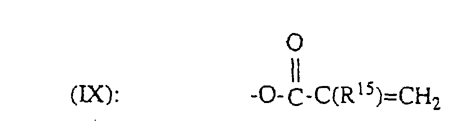
bedeuten.

7. Zusammensetzung nach Anspruch 6, **dadurch gekennzeichnet, dass** sie als Komponente (i) zumindest zwei Verbindungen der Formel (VI) enthält, wobei
[Z] in beiden Verbindungen eine -C(CH₃)₂- Gruppe bedeutet und
p in der Formel einer der beiden Verbindungen die Bedeutung 0 und in der anderen Verbindung die Bedeutung 1 hat,
und die Komponente (iii) ausgewählt ist aus 1 -Vinylpyrrolidon, Phenoxyethylacrylat, Phenoxyethylmethacrylat und einem Gemisch von mindestens zwei der genannten Verbindungen.

8. Polyoxyalkylen-Polysiloxan-Blockcopolymere mit einer Formel ausgewählt unter den Formeln
(I): R¹-(OC_{c}H_{2c})_{d}-{[T]-(C_{c}H_{2c}O)_{d-1}-(C_{c}H_{2c})}_{g}-OR¹
und 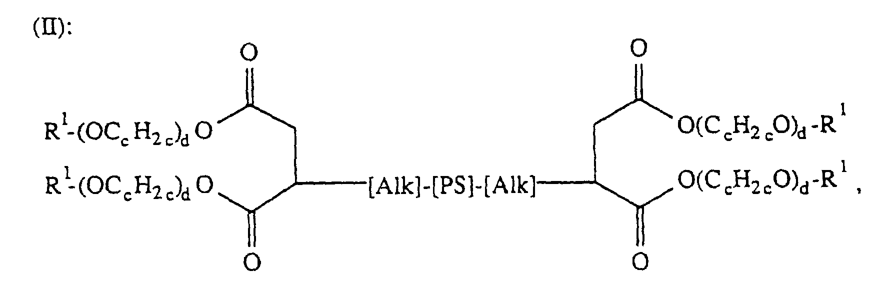 worin die einzelnen Symbole jeweils die nachfolgende Bedeutung haben:
R¹ ein Rest ausgewählt aus einem Wasserstoffatom und einer C₁-C₈-Alkylgruppe;
c eine Zahl von 1 bis 4 entsprechend der durchschnittlichen Anzahl von Kohlenstoffatomen einer Alkyleneinheit in einer Polyoxyalkylengruppe (C_{c}H_{2c}O)_{d};
d eine ganze Zahl von 7 bis 25;
g 1;
[T] eine Gruppe der Formel 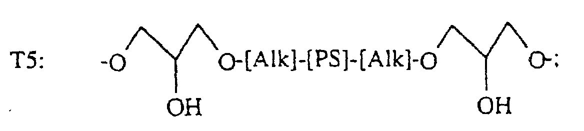
[PS] eine Polysiloxangruppe der Formel 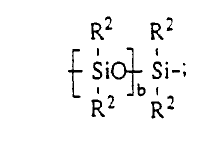
R² Methyl:
b eine ganze Zahl von 5 bis 50:
[Alk] eine Alkylengruppe mit 3 bis 10 Kohlenstoffatomen.

9. Verfahren zur Herstellung von dreidimensionalen Gegenständen aus einer Zusammensetzung nach einem der Ansprüche 1 bis 7 mittels Stereolithographie, umfassend einen Schritt, bei dem die Oberfläche einer Schicht aus der Zusammensetzung ganzflächig oder in einem vorbestimmten Muster mit einer UV/VIS-Lichtquelle bestrahlt wird, so dass sich in den bestrahlten Bereichen eine Schicht in einer gewünschten Schichtdicke verfestigt, dann eine neue Schicht aus der Zusammensetzung auf der verfestigten Schicht gebildet wird, die ebenfalls ganzflächig oder in einem vorbestimmten Muster bestrahlt wird, und wobei durch wiederholtes Beschichten und Bestrahlen dreidimensionale Gegenstände aus mehreren aneinander haftenden, verfestigten Schichten erhalten werden.

## Claims

1. A liquid radiation-curable composition for stereolithography based on at least one compound that contains radically polymerizable groups and on at least one photoinitiator suitable for this polymerization, which composition additionally comprises a polyoxyalkylene-polysiloxane block copolymer which is selected in an amount of from 5 to 50% by weight of the composition from the copolymers of the chemical formulae
(I) : R¹-(OC_{c}H_{2c})_{d}-{[T]-(C_{c}H_{2c}O)_{d-1}-(C_{c}H_{2c})}_{g}-OR¹, 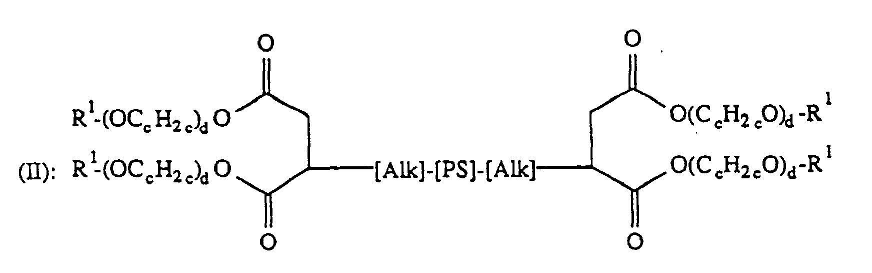
and 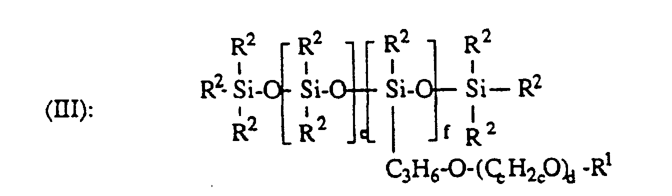 in which the individual symbols each have the following meanings:
R¹ is a member selected from hydrogen and C₁-C₈alkyl;
c is a number from 1 to 8 corresponding to the average number of carbon atoms of an alkylene unit in a polyoxyalkylene group (C_{c}H_{2c}O)_{d};
d is an integer from 1 to 100;
g is an integer from 1 to 4;
[T] is a group selected from the groups of formulae T1 to T12:
T1: -O-[PS]-O-, 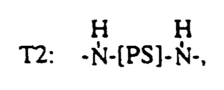
T3: -O-[Alk]-[PS]-[Alk]-O-, 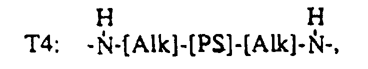 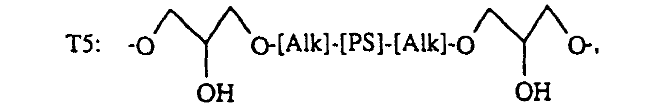 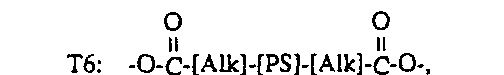 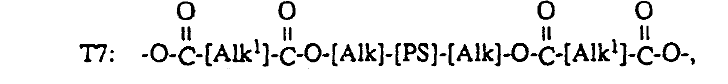 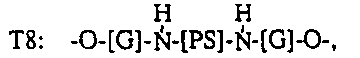
T9: -O-[G]-O-[PS]-O-[G]-O-, 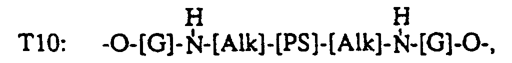
T11: -O-[G]-O-[Alk]-[PS]-[Alk]-O-[G]-O-,
T12: -O-[G]-O-(CₘH₂ₘO)ₙ-[Alk]-[PS]-[Alk]-(OCₘH₂ₘ)ₙ-O-[G]-O-;
[PS] is a polysiloxane group of formula 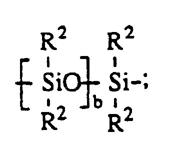
R² is a group selected from methyl and phenyl;
b is an integer from 1 to 100;
[Alk] is an alkylene group of 3 to 10 carbon atoms;
[Alk¹] is an alkylene group of 1 to 20 carbon atoms;
m is a number from 1 to 8 corresponding to the average number of carbon atoms of an alkylene unit in a polyoxyalkylene group (CₘH₂ₘO)ₙ;
n is an integer from 1 to 50;
[G] is a group of formula 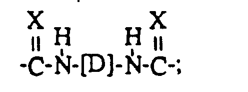
X is an atom selected from oxygen and sulfur;
[D] is a divalent organic radical containing at least 2 carbon atoms;
e is an integer from 1 to 100, and
f is an integer from 1 to 50.

2. A composition according to claim 1, wherein [D] is chosen from alkylene groups of 2 to 8 carbon atoms and divalent radicals containing not more than 30, especially not more than 20, carbon atoms, which divalent radicals contain at least one six-membered carbon ring and are unsubstituted or carry one or more straight-chain or branched C₁-C₄alkyl substituents.

3. A composition according to claim 2, wherein
R¹ is a member selected from hydrogen and C₁-C₄alkyl;
R² is a methyl group;
[Alk] is a -(CH₂)₃- group;
[Alk¹] is an alkylene group of 2 to 10 carbon atoms;
X is an oxygen atom;
[D] is a divalent organic radical selected from the radicals of the following formulae: 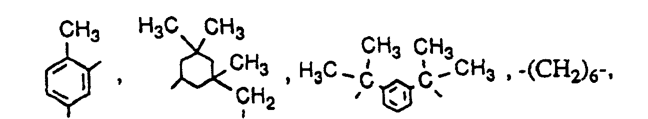 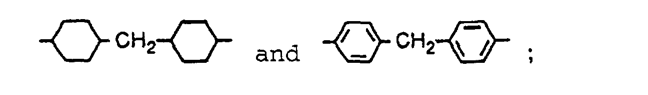
c is a number from 2 to 4;
d is an integer from 5 to 50;
b is an integer from 10 to 50;
m is a number from 2 to 4;
n is an integer from 5 to 20;
e is an integer from 1 to 50, and
f is an integer from 1 to 25.

4. A composition according to claim 3, wherein
R¹ is a methyl group;
[Alk] and [Alk¹] are each a -(CH₂)₃- group;
c is 2;
d, in the case of a compound of formula (I) or (II), is an integer from 7 to 25 and, in the case of a compound of formula (III), is an integer from 2 to 20;
g is 1;
m is 2, and
n is an integer from 7 to 20.

5. A composition according to any one of claims 1 to 4, wherein the compounds that contain radically polymerizable groups are a mixture comprising the following components:
(i) a difunctional monomeric or polymeric acrylate or methacrylate;
(ii) a tri- or polyfunctional acrylate or methacrylate;
(iii) an unsaturated monomer of formula 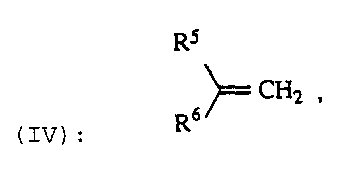 wherein
R⁵ is a member selected from hydrogen and methyl, and
R⁶ is a radical of formula 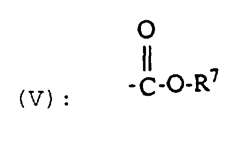 where
R⁷ is a radical selected from tetrahydrofurfuryl, cyclohexyl, 2-phenoxyethyl, benzyl, isobornyl, glycidyl, dicyclopentyl, morpholinoethyl, dimethylaminoethyl and straight-chain and branched C₁-C₂₀alkyl radicals, and, if R⁵ is hydrogen, R⁶ can, in addition to the aforementioned radicals, be a radical selected from pyrrolidon-2-yl, imidazonyl, carbazolyl, anthracenyl, phenyl, C₅-C₈cycloalkyl, naphthenyl, 2-norbornyl, pyridyl, N-caprolactamyl, formamidyl, acetamidyl and toluenyl.

6. A composition according to claim 5 comprising as component (i) at least one compound of formula 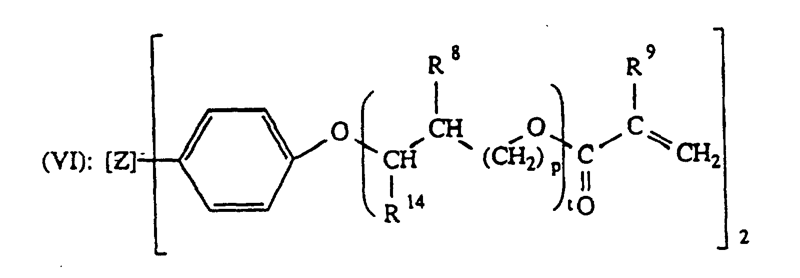 wherein
p is 0 or 1,
t is 0 or 1 or, if p is 0, is an integer from 1 to 3,
[Z] is -O-, -S-, -SO₂- or -C(R¹⁰)(R¹¹)-,
R¹⁰ and
R¹¹ are each independently of the other a member selected from hydrogen, -CF₃ and methyl,
R¹⁴, if p is 0, is hydrogen or methyl and,
if p is 1, is hydrogen,
R⁸, if p is 0, is hydrogen and
if p is 1, is hydroxyl, and
R⁹ is hydrogen or methyl; and
as component (ii) a triacrylate or trimethacrylate of formula
(VII): R¹²-CH₂-C(CH₂-R¹³)₃
wherein
R¹² is methyl or a radical of formula 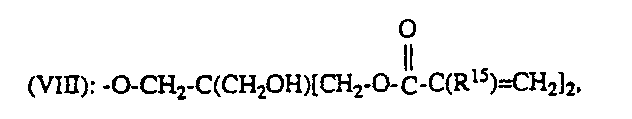
R¹⁵ are each independently of the other hydrogen or methyl, and
R¹³ is a radical of formula

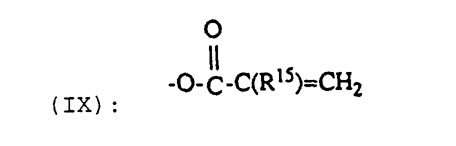

7. A composition according to claim 6, which comprises as component (i) at least two compounds of formula (VI) in which
[Z] in both compounds is a -C(CH₃)₂- group, and
p in the formula of one of the two compounds is 0 and in the other is 1,
and component (iii) is selected from 1-vinylpyrrolidone, phenoxyethyl acrylate, phenoxyethyl methacrylate and a mixture of at least two of the cited compounds.

8. A polyoxyalkylene-polysiloxane block copolymer having a formula selected from the formulae
(I): R¹-(OC_{c}H_{2c})_{d}-{[T]-(C_{c}H_{2c}O)_{d-1}-(C_{c}H_{2c})}_{g}-OR¹,
and 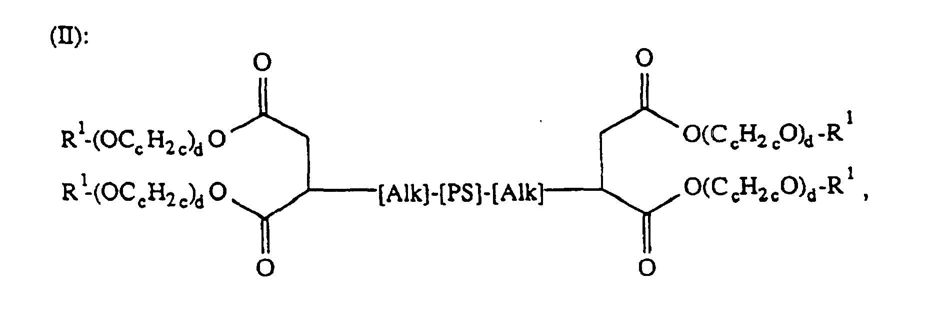 wherein the individual symbols each have the following meanings:
R¹ is a member selected from hydrogen and C₁-C₈alkyl;
c is a number from 1 to 4 corresponding to the average number of carbon atoms of an alkylene unit in a polyoxyalkylene group (C_{c}H_{2c}O)_{d};
d is an integer from 7 to 25;
g is 1;
[T] is a group of formula 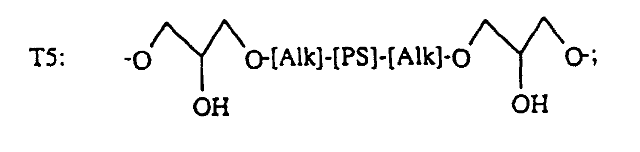
[PS] is a polysiloxane group of formula 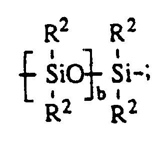
R² is methyl;
b is an integer from 5 to 50;
[Alk] is an alkylene group of 3 to 10 carbon atoms.

9. A process for the production of three-dimensional objects from a composition according to any one of claims 1 to 7 by stereolithography, which comprises a step of irradiating a layer of the composition over the entire surface or in a predetermined pattern with a UV/VIS light source, such that within the irradiated areas a layer solidifies in a desired layer thickness, then a new layer of the composition is formed on the solidified layer, which layer is likewise irradiated over the entire surface or in a predetermined pattern, and such that by repeated coating and irradiation three-dimensional objects are formed from a plurality of solidified layers which adhere to one another.

## Revendications

1. Composition durcissable par irradiation, pour la stéréolithographie, à base d'au moins un composé, qui présente des groupes polymérisables par voie radicalaire, et au moins un photoamorceur approprié pour cette polymérisation, **caractérisée en ce que** ce qu'elle contient de plus un copolymère séquencé polyoxyalkylène-polysiloxane en une quantité de 5 à 50 % en poids de la composition, qui est choisi parmi les copolymères de formules chimiques :
R¹-(OC_{c}H_{2c})_{d})-([T]-C_{c}H_{2c}O)_{d-1}-(C_{c}H_{2c}))_{g}-OR¹ (I) 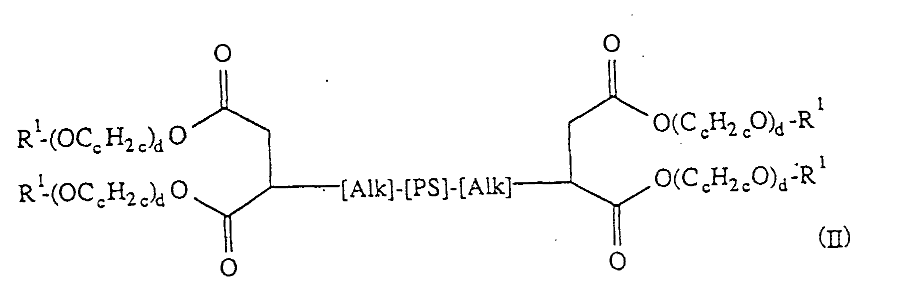
et 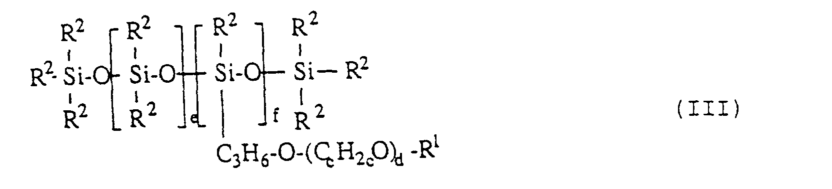 où les différents symboles ont à chaque fois la signification suivante :
R¹ un reste choisi parmi un atome d'hydrogène et un groupe alkyle en C₁-C₈ ;
c un nombre de 1 à 8, correspondant au nombre moyen d'atomes de carbone d'une unité alkylène dans un groupe polyalkylène (C_{c}H_{2c}O)_{d} ;
d un nombre entier de 1 à 100 ;
g un nombre entier de 1 à 4 ;
[T] un groupe choisi parmi les groupes de formules T1 à T12 :
T1: -O-[PS]-O-, 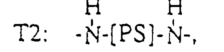
T3: -O-[Alk]-[PS]-[Alk]-O-, 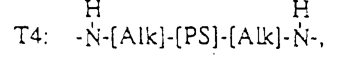 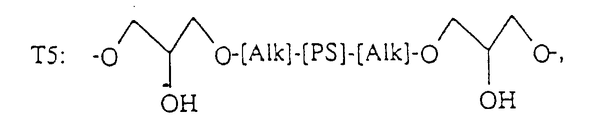 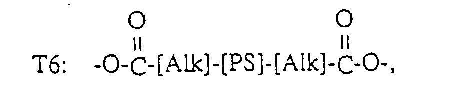 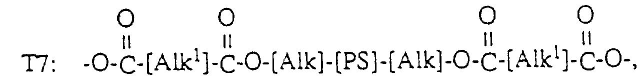 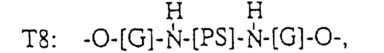
T9: -O-[G]-O-[PS]-O-[G]-O-, 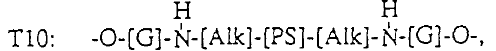
T11: -O-[G]-O-[Alk]-[PS]-[Alk]-O-[G]-O-,
T12: -O-[G]-O-(CₘH₂ₘO)ₙ-[Alk]-[PS]-[Alk]-(OCₘH₂ₘ)ₙ-O-[G]-O-;
[PS] un groupe polysiloxane de formule 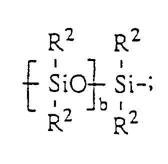
R² un groupe choisi parmi les groupes méthyle et phényle ;
b un nombre entier de 1 à 100 ;
[Alk] un groupe alkylène avec de 3 à 10 atomes de carbone ;
[Alk¹] un groupe alkylène avec de 1 à 20 atomes de carbone ;
m un nombre de 1 à 8, correspondant au nombre moyen d'atomes de carbone d'une unité alkylène dans un groupe polyoxyalkylène (CₘH₂ₘO)ₙ ;
n un nombre entier de 1 à 50 ;
[G] un groupe de formule 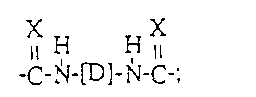
X un atome choisi parmi un atome d'oxygène et un atome de soufre ;
[D] un reste organique bivalent avec au moins deux atomes de carbone ;
e un nombre entier de 1 à 100 ; et
f un nombre entier de 1 à 50.

2. Composition selon la revendication 1, **caractérisée en ce que** l'on choisit [D] de préférence parmi les groupes alkylène avec de 2 à 8 atomes de carbone et des restes bivalents avec au maximum 30, en particulier avec au maximum 20 atomes de carbone, où ces restes bivalents comportent au moins un cycle carboné à 6 chaînons et sont non substitués ou présentent un ou plusieurs substituants alkyle en C₁-C₄ à chaîne linéaire ou ramifiée.

3. Composition selon la revendication 2, **caractérisée en ce que** :
R¹ est un reste choisi parmi un atome d'hydrogène et un groupe alkyle en C₁-C₄ ;
R² représente un groupe méthyle ;
[Alk] représente un groupe en -(CH₂)₃-;
[Alk¹] représente un groupe alkylène avec de 2 à 10,
X représente un atome d'oxygène ;
[D] un reste organique bivalent choisi parmi les restes de formules suivantes : 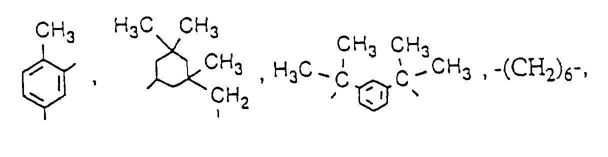 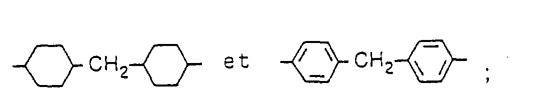
c représente un nombre de 2 à 4 ;
d un nombre entier de 5 à 50 ;
b un nombre entier de 10 à 50 ;
m un nombre de 2 à 4 ;
n un nombre entier de 5 à 20 ;
e un nombre entier de 1 à 50 ; et
f un nombre entier de 1 à 25.

4. Composition selon la revendication 3, **caractérisée en ce que** :
R¹ représente un groupe méthyle ;
[Alk] et [Alk¹] représentent à chaque fois un groupe (CH₂)₃ ;
c vaut 2 ;
d représente dans le cas d'un composé de formule (I) ou (II) un nombre entier de 7 à 25, et dans le cas d'un composé de formule (III) un nombre entier de 2 à 20 ;
g représente 1 ;
m vaut 2 ; et
n représente un nombre entier de 7 à 20.

5. Composition selon l'une des revendications 1 à 4, **caractérisée en ce que** les composés qui représentent des groupes polymérisables par voie radicalaire, représentent un mélange qui contient les composants suivants :
(i) un acrylate ou méthacrylate bifonctionnel monomère ou polymère;
(ii) un acrylate ou méthacrylate tri- ou polyfonctionnels;
(iii) un composé monomère insaturé de formule : 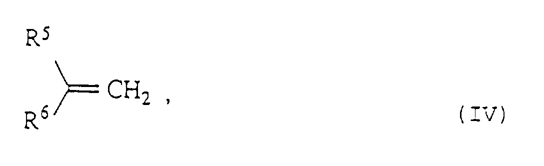 où
R⁵ est un reste choisi parmi un atome d'hydrogène et un groupe méthyle et
R⁶ un reste de formule : 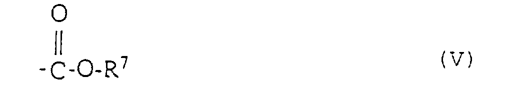
R⁷ étant un reste choisi parmi les restes tétrahydrofurfuryle, cyclohexyle, 2-phénoxyéthyle, benzyle, isobornyle, glycidyle, dicyclopentyle, morpholinoéthyle, diméthylaminoéthyle, ainsi qu'un alkyle en C₁-C₂₀ à chaîne linéaire ou ramifiée, et dans le cas où R⁵ représente un atome d'hydrogène, R⁶ est de plus des restes précités, également choisi un reste parmi les restes pyrrolidon-2-yle, imidazonyle, carbazolyle, anthracényle, phényle, cycloalkyle en C₅-C₈, naphtényle, norbornyle-2, pyridyle, N-caprolactamyle, formamidyle, acétamidyle et toluyle.

6. Composition selon la revendication 5, **caractérisée en ce qu'**elle contient en tant que composant (i) au moins un composé de formule : 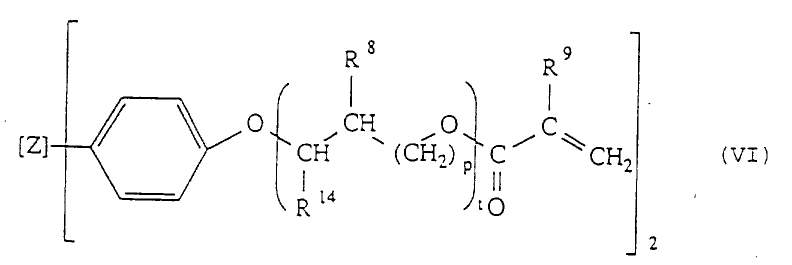 où
P vaur 0 ou 1,
t vaut 0 ou 1, ou lorsque p vaut 0, un nombre entier de 1 à 3 ;
[Z] représente -O-, -S-, -SO₂- ou -C(R¹⁰)(R¹¹)-,
R¹⁰ de même que
R¹¹ représentent chacun indépendamment l'un de l'autre, un reste choisi parmi un atome d'hydrogène, CF₃ et un groupe méthyle,
R¹⁴ lorsque p vaut 0, il un atome d'hydrogène ou un groupe méthyle, et lorsque p vaut 1, un atome d'hydrogène,
R⁸ lorsque p vaut 0, représente un atome d'hydrogène, et lorsque p vaut 1, un groupe hydroxyle, et
R⁹ représente un atome d'hydrogène ou un groupe méthyle, et
en tant que composant (ii) un triacrylate ou un triméthacrylate de formule (VII) :
R¹²-CH₂-C(CH₂-R¹³)₃ (VII)
où
R¹² représente un groupe méthyle ou un reste de formule : 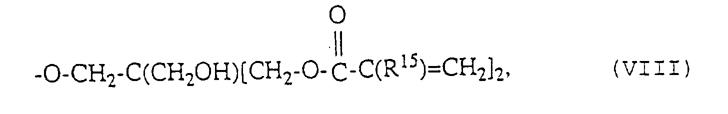
R¹⁵ représente chacun, indépendamment l'un de l'autre, un atome d'hydrogène ou un groupe méthyle, et
R¹³ représente un reste de formule

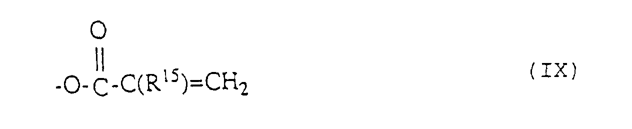

7. Composition selon la revendication 6, **caractérisé en ce que** le composant (i) contient au moins deux composés différents de formule (VI) où
[Z] représente dans les deux composés un groupe -C(CH₃)₂-, et
p dans la formule d'un des deux composéx vaut 0, dans l'autre composé vaut 1,
et comme composant (iii) est choisi parmi la 1-vinylpyrrolidone, soit l'acrylate de phénoxyéthyle, le méthacrylate de phénoxyéthyle ou un mélange d'au moins deux des composés cités.

8. Copolymère séquencé polyoxyalkylène-polysiloxane répondant à une formule choisie parmi les formules ci-dessous :
R¹-(OC_{c}H_{2c})_{d})-([T]-C_{c}H_{2c}O)_{d-1}-(C_{c}H_{2c}))_{g}-OR¹ (I)
et 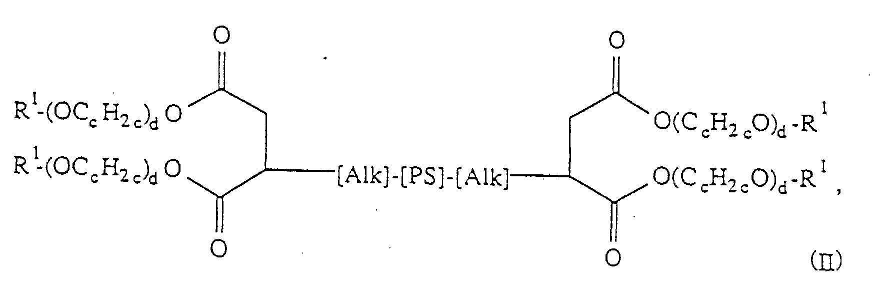 où les différents symboles ont à chaque fois la signification suivante :
R¹ représente un reste choisi parmi un atome d'hydrogène et un groupe alkyle en C₁-C₈ ;
c est un nombre de 1 à 4 correspondant au nombre moyen d'atomes de carbone d'une unité alkylène dans un groupe polyoxyalkylène (C_{c}H_{2c}O)_{d} ;
d est un nombre entier de 7 à 25 ;
g vaut 1 ;
[T] représente un groupe de formule : 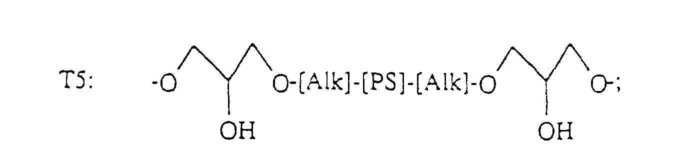
[PS] représente un groupe polysiloxane de formule 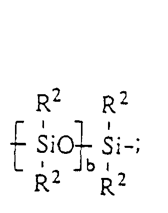
R² représente un méthyle ;
b est un nombre de 5 à 50 ;
[Alk] représente un groupe alkylène avec de 3 à 10 atomes de carbone.

9. Procédé pour la préparation d'objets à trois dimensions à partir d'une composition selon l'une des revendications 1 à 7 au moyen de stéréolithographie, comprenant une étape, au cours de laquelle on irradie une couche de la composition sur la totalité de la surface, ou delon un modèle prédéterminé, avec une source de lumière UV/VIS, de façon telle sorte qu'une couche avec une épaisseur voulue se consolide dans les domaines irradiés, ensuite on forme une nouvelle couche de la composition sur la couche consolidée, que l'on irradie également sur la totalité de la surface ou selon un modèle prédéterminé, en obtenant par revêtement et irradiation répétés des objets tridimensionnels constitués de plusieurs couches consolidées adhérentes les unes aux autres.
